# EUROPÄISCHE PATENTSCHRIFT

(11) **EP 2 466 751 B1**
(45) Veröffentlichungstag und Bekanntmachung des Hinweises auf die Patenterteilung: **17.10.2012**
(21) Anmeldenummer: 11188729.5
(22) Anmeldetag: 11.11.2011
(51) Int. Cl.: H03K 17/082, H03K 17/042, H03K 17/0412, H02M 1/088, H03K 17/12

(54) **Leistungshalbleitersystem**
Power semiconductor system
Système semi-conducteur de puissance

(30) Priorität: 16.12.2010 DE 102010063274
(43) Veröffentlichungstag der Anmeldung: 20.06.2012
(73) Patentinhaber: SEMIKRON Elektronik GmbH & Co. KG, 90431 Nürnberg (DE)
(72) Erfinder: Königsmann, Gunter, 91058 Erlangen (DE); Mitzel, Mario, 90409 Nürnberg (DE); Calisir, Haldun, 90522 Oberasbach (DE)

(56) Entgegenhaltungen:
- WO-A1-2004/102806
- DE-A1- 10 351 843
- DE-A1- 19 804 623

## Beschreibung

Die Erfindung betrifft ein Leistungshalbleitersystem.

Ein in Rede stehendes Leistungshalbleitersystem umfasst in der Regel mindestens einen Leistungshalbleiterschalter, z.B. einen IGBT (insulated gate bipolar transistor) oder einen MOSFET (metal oxide semiconductor field effect transistor). Ein oder mehrere Leistungshalbleiterschalter sind außerdem in der Regel in einem Leistungsmodul zusammengefasst bzw. integriert. Außerdem enthält das Leistungshalbleitersystem eine, den oder die Leistungshalbleiterschalter ansteuernde Treiberschaltung, oft kurz Treiber genannt. Letztere übersetzt ein leistungsschwaches logisches Schaltsignal in ein den Leistungshalbleiterschalter tatsächlich schaltendes, in der Regel leistungsstarkes Schaltsignal, welches außerdem z.B. auf Hochspannungspotential liegt. Die Treiberschaltung ist typischerweise nicht zwangsläufig Teil des Leistungsmoduls.

Insbesondere in Leistungshalbleitersystemen, die mehrere Leistungshalbleiterschalter enthalten, sind letztere oft lastseitig (z.B. bezüglich ihrer Emitter und Kollektoren) parallel geschaltet, um besonders große Ströme oder Spannungen schalten zu können. Bei derart parallelisierten Leistungshalbleiterschaltern ist es sinnvoll, diese auch bezüglich ihrer Steueranschlüsse (z.B. Gates) an einem einzigen Steuerausgang der Treiberschaltung parallel zu schalten.

Ziel ist es besonders bei der o.g. Parallelschaltung, die Leistungshalbleiterschalter so gleichzeitig wie möglich und mit so gleicher Geschwindigkeit wie möglich schalten zu lassen. Hierdurch soll eine gleichmäßige Stromaufteilung erreicht werden, d.h. jeder der parallelisierten Leistungshalbleiterschalter soll möglichst den gleichen Anteil eines Gesamtstroms aufnehmen.

Ein Problem, welches hierbei auftritt, ist, dass nicht sämtliche Leistungshalbleiterschalter tatsächlich gleich schalten. Außerdem erfährt beispielsweise ein IGBT in dem Moment, in welchem er schaltet, eine starke Stromänderung an seinem Emitter. Zumindest der parasitäre ohmsche Widerstand bzw. die Induktivität einer Emitterzuleitung verursacht hierbei bei besonders hohen zu schaltenden Strömen leicht einen Potentialsprung am Emitter im Bereich von beispielsweise 100 Volt. Im Falle eines IGBT ändert sich hierdurch auch die Spannung zwischen dessen Emitter und Gate. Da der Treiber in der Regel dieser Potentialschwankung nicht augenblicklich folgen kann, ändert sich die anliegende Gate-Emitter-Spannung und somit wiederum die Schaltgeschwindigkeit des Transistors. Über die o.g. Parallelschaltung der Gates ändert sich daher auch die Schaltgeschwindigkeit sämtlicher parallelgeschalteter Leistungshalbleiterschalter.

Problematisch ist also die Verbindung zwischen Treiber und Halbleiterschalter, insbesondere die jeweilige Gate- und Emitter-Verbindung. Angesprochen sind die Anschlussleitungen zwischen den jeweiligen Kontakten bzw. Anschlüssen des Treibers und dem Emitter- bzw. Gate-Anschluss am Halbleiterschalter.

Um die o.g. Effekte zu vermeiden, ist es beispielsweise aus der WO 2004/102806 A1 bekannt, in die jeweilige Gate- und Emitter-Verbindung, also die betreffende Anschlussleitung, eine Gleichtaktdrossel einzuschalten. Die Gleichtaktdrossel weist insgesamt zwei, und damit je eine Wicklung auf, welche in die entsprechende Anschlussleitung zum Gate und zum Emitter eingeschaltet wird, und eine Kopplung zwischen beiden Wicklungen. Eine derartige Gleichtaktdrossel überträgt dann einen Potentialversatz zwischen dem Emitter-Kontakt des Treibers und dem Emitter-Anschluss des Leistungshalbleiterschalters in die entsprechende Verbindungsleitung zwischen dem Gate-Kontakt des Treibers und dem Gate-Anschluss des Leistungshalbleiterschalters. Die Spannungsdifferenz zwischen Gate und Emitter des Leistungshalbleiterschalters ist daher nahezu unabhängig vom Spannungsversatz zwischen Leistungshalbleiterschalter und Treiber.

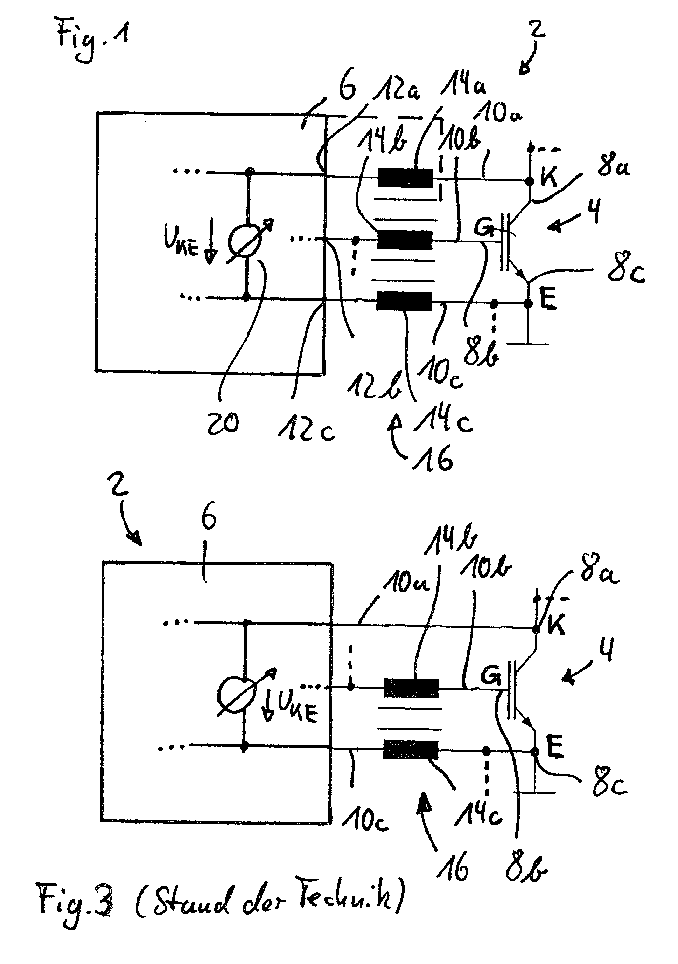

Fig. 3 zeigt ein Leistungshalbleitersystem 2 gemäß Stand der Technik mit einem Leistungshalbleiterschalter 4 und einer Treiberschaltung 6, welche über Anschlussleitungen 10a-c miteinander verbunden sind. Eine Parallelschaltung mit weiteren, nicht dargestellten Halbleiterschaltern ist symbolisch durch gestrichelte Verbindungsleitungen angedeutet. In die am Gate G als Anschluss 8b und am Emitter E als Anschluss 8c angeschlossenen Anschlussleitungen 10b,c ist eine Gleichtaktdrossel 16 mit zwei Wicklungen 14b,c angeschlossen. Diese verhindert insbesondere beim Schaltvorgang des Leistungshalbleiterschalters 4 eine Übertragung eines Potentialsprungs am Emitter E auf parallelisierte weitere, nicht dargestellte Leistungshalbleiterschalter.

Wünschenswert ist in entsprechenden Leistungsmodulen in der Regel eine sogenannte Kurzschlussdetektion. Der Treiber weist hierzu einen weiteren Kontakt auf, welcher mit dem Kollektor K, also dem Anschluss 8a des Leistungshalbleiterschalters verbunden ist. So kann eine Kollektor-Emitter-Spannung U_{KE} am Halbleiterschalter 4 in der Treiberschaltung 2 erfasst und ausgewertet oder von dieser zur weiteren Verarbeitung weitergeleitet werden. Hierbei sind Spannungen im Bereich von etwa 100mV bis zu einigen Volt zu messen. Eine derartige Messung gestaltet sich bei Schaltvorgängen und oben genannten Sprüngen des Potentials des Emitters E am Leistungshalbleiterschalter 4 im 100V-Bereich schwierig.

Entsprechende Messungen im Treiber sind daher fehlerbehaftet. Bei einem MOSFET als Leistungshalbleiterschalter wirkt sich der o.g. Spannungsversatz bzw. -sprung noch stärker aus als bei einem IGBT, da hier die Spannungen am eingeschalteten Bauteil (Source-Drain-Spannung, entspricht U_{KE} beim IGBT), d.h. am leitenden MOSFET im Regelfall deutlich geringer sind als beim leitenden IGBT die Kollektor-Emitter-Spannung. Auch durch die oben genannte Gleichtaktdrossel gelingt es nicht, den Potentialversatz zwischen Emitter des Leistungshalbleiterschalters und Emitter-Kontakt des Treibers in der oben genannten Spannungsmessung zu bereinigen.

Aufgabe der Erfindung ist es, ein verbessertes Leistungshalbleitersystem anzugeben.

Die Aufgabe wird gelöst durch ein Leistungshalbleitersystem gemäß Patentanspruch 1, welches wie oben beschrieben einen Leistungshalbleiterschalter mit drei Anschlüssen und eine diesen steuernde Treiberschaltung enthält. Die drei Anschlüsse sind über drei Anschlussleitungen mit entsprechenden Kontakten, also Ein- oder Ausgängen, der Treiberschaltung verbunden. Erfindungsgemäß enthält das Leistungshalbleitersystem außerdem für jeden Leistungshalbleiterschalter eine Gleichtaktdrossel mit drei gekoppelten Wicklungen, wobei je eine der Wicklungen in je eine der Anschlussleitungen geschaltet ist. Mit anderen Worten ist also jedem Leistungshalbleiterschalter unmittelbar eine Gleichtaktdrossel vorgeschaltet. Eine eventuelle Parallelschaltung der Schalteingänge von Leistungshalbleiterschaltern erfolgt erst auf der der Treiberschaltung zugewandten Seite der Drosseln.

Der Leistungshalbleiter ist hierbei in der Regel ein IGBT oder MOSFET, deren Anschlüsse sind dann Gate, Emitter und Kollektor bzw. Gate, Source und Drain.

Ein entstehender Potentialversatz zwischen dem Emitter (Source) des Leistungshalbleiterschalters und Emitter(Source)-Kontakt des Treibers wird so nicht nur in die Gate-Anschlussleitung, sondern auch in die Kollektor-Anschlussleitung transformiert und bereinigt somit auch die im Treiber gemessene Spannung zwischen Kollektor und Emitter bzw. Source und Drain des Leistungshalbleiterschalters von dem o.g. Potentialversatz. Der Potentialversatz ist damit aus der Messung entfernt, die Messung erfolgt wesentlich genauer, insbesondere bei Schaltvorgängen.

In einer bevorzugten Ausführungsform der Erfindung ist die jeweilige Drossel in der Treiberschaltung integriert. In der Regel sind also mehrere Drosseln, eine für jeden Leistungshalbleiterschalter, im Treiber vorhanden. An einen erfindungsgemäßen Treiber kann besonders einfach ein herkömmlicher Leistungshalbleiterschalter angeschlossen werden, um ein erfindungsgemäßes Leistungshalbleitersystem zu erhalten. Spezielle Leistungshalbleiterschalter oder entsprechende Leistungsmodule sind nicht nötig. Die Modifikation bestehender Systeme erfolgt im Treiber.

In einer alternativen Ausführungsform der Erfindung ist der Leistungshalbleiterschalter Teil eines Leistungsmoduls. Die zu diesem gehörende Gleichtaktdrossel ist dann im Leistungsmodul enthalten bzw. integriert. So findet alternativ die Modifikation im Leistungsmodul statt und herkömmliche Treiber können weiter verwendet werden.

In einer weiteren Alternative ist die Drossel zwischen jeweils unveränderte Treiber und Leistungsmodule bz. Leistungshalbleiter geschaltet. Hier muss keine der vorgenannten Einheiten modifiziert werden. Die Erfindung greift auf Ebene des Leistungshalbleitersystems.

In einer bevorzugten Ausführungsform der Erfindung weist die Treiberschaltung für gleichartige Anschlüsse, z.B. die Gate- und Emitter-Anschlüsse, verschiedener Leistungshalbleiterschalter nur jeweils einen einzigen Kontakt auf. Mit anderen Worten sind die jeweiligen von diesen Anschlüssen zum Treiber führenden Anschlussleitungen treiberseitig parallel geschaltet. Am Treiber muss daher stets nur ein einziger Kontakt bzw. Anschluss für sämtliche gleichartigen Anschlüsse aller Leistungshalbleiter vorgesehen sein.

In einer bevorzugten Ausführungsform der Erfindung enthält die Treiberschaltung eine Messeinrichtung, welche dazu dient, eine Spannung zwischen zweien der Anschlüsse eines Leistungshalbleiterschalters zu ermitteln. Insbesondere dient eine entsprechende Messeinrichtung zur oben genannten Kurzschlussdetektion. Gemessen wird also die Spannung zwischen dem Emitter(Source)- und dem Kollektor(Drain)-Anschluss eines Halbleiterschalters. Die Messung ist aufgrund der Erfindung vom o.g. Potentialversatz fehlerbereinigt, da insbesondere auch in der Kollektor-Anschlussleitung nun eine gekoppelte Spule der Drossel liegt, die den Potentialversatz in der Emitter- und Gate-Anschlussleitung nun auch auf die Kollektor-Anschlussleitung überträgt. Im Treiber ist die Messeinrichtung mit betreffenden Kontakten verbunden, die an die betreffenden, zu den zu messenden Anschlüssen führenden Anschlussleitungen angeschlossen sind.

In einer bevorzugten Variante dieser Ausführungsform enthält der Treiber für jeden Leistungshalbleiter eine eigene Messeinrichtung. Hierbei ist dann allerdings für jeden Halbleiterschalter zumindest ein eigener Kontakt am Treiber vorzusehen, um hier auch die jeweiligen individuellen Spannungen messen zu können. Z.B. sind also alle jeweiligen Anschlussleitungen der Kollektor-Anschlüsse auf einen separaten Kontakt bzw. Eingang am Treiber geführt.

Für eine weitere Beschreibung der Erfindung wird auf die Ausführungsbeispiele der Zeichnungen verwiesen. Es zeigen, jeweils in einer schematischen Prinzipskizze:
Fig. 1 ein Leistungshalbleitersystem gemäß der Erfindung,
Fig. 2 ein alternatives Leistungshalbleitersystem mit parallel geschalteten Halbleiterschaltern,
Fig. 3 ein Leistungshalbleitersystem gemäß Stand der Technik.

Fig. 1 zeigt ein Leistungshalbleitersystem 2, welches einen Leistungshalbleiterschalter 4 und eine Treiberschaltung 6 beinhaltet. Der Leistungshalbleiterschalter 4 weist drei Anschlüsse 8a-c auf. Da es sich um einen IGBT handelt sind diese Kollektor K, Gate G und Emitter E. Jeder der Anschlüsse 8a-c ist über eine Anschlussleitung 10a-c an einen von 3 Kontakten 12a-c der Treiberschaltung 6 angeschlossen. Eine Parallelisierung mit weiteren, nicht dargestellten Halbleiterschaltern, die an der Treiberschaltung 6 angeschlossen sind, ist symbolisch durch gestrichelte Verbindungsleitungen angedeutet. Die Kontakte 12a,c bilden (Mess-)Eingänge des Treibers, der Kontakt 12b einen (Steuer-)Ausgang.

Erfindungsgemäß ist in jede der Anschlussleitungen 10a-c eine Wicklung 14a-c einer Gleichtaktdrossel 16 geschaltet, wobei sämtliche Wicklungen 14a-c zueinander magnetisch gekoppelt sind.

Ein Potentialsprung am Emitter E, z.B. durch einen Schaltvorgang des Leistungshalbleiterschalters 4, wird durch die Gleichtaktdrossel 16 auf die Potentiale des Gates G und des Kollektors K übertragen.

Fig. 1 zeigt außerdem eine bevorzugte Ausführungsform der Erfindung, in der nämlich die Treiberschaltung 6 eine Messeinrichtung 20 enthält, welche eine Spannung U_{KE} zwischen Kollektor K und Emitter E des Leistungshalbleiterschalters 4 misst. Diese dient beispielsweise zur Kurzschlussdetektion am Leistungshalbleiterschalter 4.

Die Gleichtaktdrossel 16 ist als separates Bauteil zwischen die Treiberschaltung 6 und den Leistungshalbleiterschalter 4 geschaltet. In einer gestrichelt nur angedeuteten Alternative ist die Gleichtaktdrossel 16 als Bauteil in die Treiberschaltung 6 integriert.

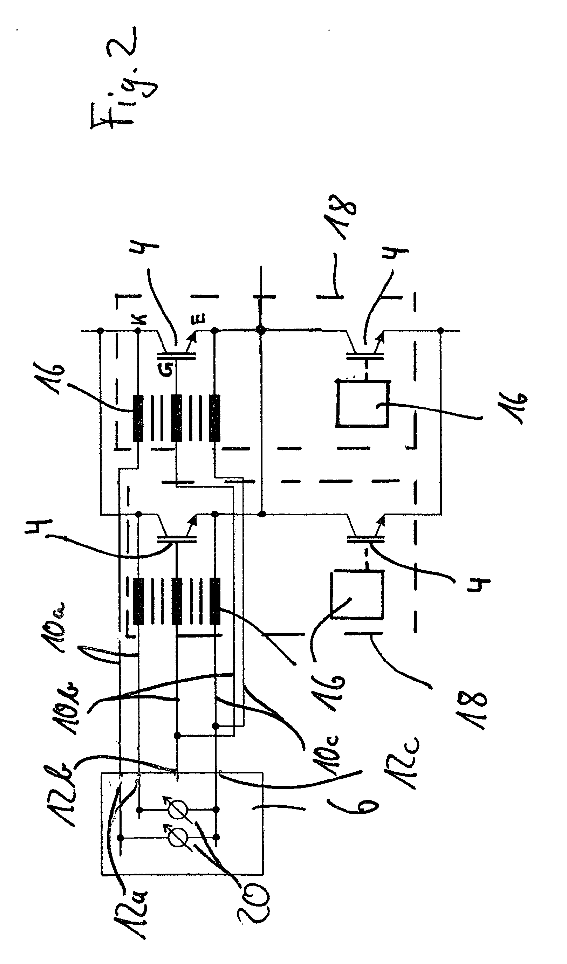

Fig.2 zeigt ein alternatives Leistungshalbleitersystem 2, bei dem eine einzige Treiberschaltung 6 mehrere (hier die beiden oberen gezeigten) Leistungshalbleiterschalter 4 bedient. Die Leistungshalbleiterschalter 4 sind zu jeweils zwei Exemplaren nach Art einer Halbbrücke in einem Leistungsmodul 18 zusammengefasst. Die jeweils zu einem Leistungshalbleiterschalter 4 gehörenden Gleichtaktdrosseln 16 sind im betreffenden Leistungsmodul 18 integriert. Die unteren beiden Leistungshalbleiterschalter 4 werden von einem weiteren, nicht dargestellten Treiber bedient und bilden ein eigenes, dem oberen entsprechendes Leistungshalbleitersystem.

In Fig. 2 ist insbesondere die lastseitige Parallelschaltung der Emitter E und Kollektoren K aller Leistungshalbleiterschalter 4 zu sehen. Für die jeweiligen Anschlussleitungen 10b und 10c erfolgt zur Treiberschaltung hin ebenfalls eine Parallelschaltung. An der Treiberschaltung 6 ist daher für die Anschlussleitungen 10b und 10c nur jeweils ein einziger, gemeinsamer Kontakt 12b,c vorgesehen.

Da hier jedoch separat eine Messung der Kollektor-Emitter-Spannung U_{KE} für jeden der Leistungshalbleiterschalter 4 erfolgen soll, sind alle Anschlussleitungen 10a auf je einen separaten Eingang bzw. Kontakt 12a an der Treiberschaltung 6 geführt. Es sind daher auch entsprechend viele Messeinrichtungen 20 in der Treiberschaltung 6 vorgesehen.

### Bezugszeichenliste

- 2: Leistungshalbleitersystem
- 4: Leistungshalbleiterschalter
- 6: Treiberschaltung
- 8a-c: Anschluss
- 10a-c: Anschlussleitung
- 12a-c: Kontakt
- 14a-c: Wicklung
- 16: Gleichtaktdrossel
- 18: Leistungsmodul
- 20: Messeinrichtung

- K: Kollektor
- G: Gate
- E: Emitter
- U_{KE}: Spannung

## Patentansprüche

1. Leistungshalbleitersystem (2),
- mit mindestens einem, drei Anschlüsse (8a-c) aufweisenden Leistungshalbleiterschalter (4),
- und mit einer den Leistungshalbleiterschalter (4) steuernden Treiberschaltung (6),
- wobei jeder der Anschlüsse (8a-c) über je eine Anschlussleitung (10a-c) an einem Kontakt (12a-c) der Treiberschaltung (6) angeschlossen ist,
- bei dem jedem Leistungshalbleiterschalter (4) eine Gleichtaktdrossel (16) mit drei gekoppelten Wicklungen (14a-c) zugeordnet ist,
- wobei je eine der Wicklungen (14a-c) in je eine der Anschlussleitungen (10a-c) des jeweiligen Leistungshalbleiterschalters (4) geschaltet ist.

2. Leistungshalbleitersystem (2) nach Anspruch 1, bei dem die Gleichtaktdrossel (16) in der Treiberschaltung (6) integriert ist.

3. Leistungshalbleitersystem (2) nach Anspruch 1, wobei der Leistungshalbleiterschalter (4) Teil eines Leistungsmoduls (18) ist, bei dem die Gleichtaktdrossel (16) im Leistungsmodul (18) integriert ist.

4. Leistungshalbleitersystem (2) nach einem der vorhergehenden Ansprüche, bei dem die Treiberschaltung (6) für gleichartige Anschlüsse (8a-c) verschiedener Leistungshalbleiterschalter (4) einen einzigen Kontakt (12a-c) aufweist.

5. Leistungshalbleitersystem (2) nach einem der vorhergehenden Ansprüche, bei dem die Treiberschaltung (6) mindestens eine, eine Spannung (U_{KE}) zwischen zwei der Anschlüsse (8a-c) des Leistungshalbleiterschalters (4) ermittelnde Messeinrichtung (20) enthält.

6. Leistungshalbleitersystem (2) nach Anspruch 5, das für jeden Leistungshalbleiterschalter (4) eine eigene Messeinrichtung (20) enthält.

## Claims

1. A power semiconductor system (2),
- with at least one power semiconductor switch (4) having three terminals (8a-c),
- and with a driver circuit (6) which controls the power semiconductor switch (4),
- wherein each of the terminals (8a-c) is connected to a contact (12a-c) of the driver circuit (6) via in each case one connection line (10a-c),
- in which each power semiconductor switch (4) is assigned a common-mode choke (16) with three coupled windings (14a-c),
- wherein each of the windings (14a-c) is connected into one of the connection lines (10a-c) of the respective power semiconductor switch (4).

2. The power semiconductor system (2) according to Claim 1, in which the common-mode choke (16) is integrated in the driver circuit (6).

3. The power semiconductor system (2) according to Claim 1, wherein the power semiconductor switch (4) is part of a power module (18), in which the common-mode choke (16) is integrated in the power module (18).

4. The power semiconductor system (2) according to one of the preceding claims, in which the driver circuit (6) has a single contact (12a-c) for terminals (8a-c) of the same type of different power semiconductor switches (4).

5. The power semiconductor system (2) according to one of the preceding claims, in which the driver circuit (6) contains at least one measurement means (20) which determines a voltage (U_{KE}) between two of the terminals (8a-c) of the power semiconductor switch (4).

6. The power semiconductor system (2) according to Claim 5, which contains a dedicated measurement means (20) for each power semiconductor switch (4).

## Revendications

1. Système semi-conducteur de puissance (2),
- avec au moins un interrupteur semi-conducteur de puissance (4) pourvu de trois connexions (8a-c),
- et avec un circuit d'attaque (6) commandant l'interrupteur semi-conducteur de puissance (4),
- chacune des connexions (8a-c) étant raccordée par une ligne de connexion (10a-c) respective à un contact (12a-c) du circuit d'attaque (6),
- à chaque interrupteur semi-conducteur de puissance (4) étant associée une inductance en mode commun (16) avec trois enroulements (14a-c) couplés,
- chacun des enroulements (14a-c) étant monté sur chacune des lignes de connexion (10a-c) de l'interrupteur semi-conducteur de puissance (4) correspondant.

2. Système semi-conducteur de puissance (2) selon la revendication 1, l'inductance en mode commun (16) étant intégrée au circuit d'attaque (6).

3. Système semi-conducteur de puissance (2) selon la revendication 1, dans lequel l'interrupteur semi-conducteur de puissance (4) fait partie d'un module de puissance (18), l'inductance en mode commun (16) étant intégrée au module de puissance (18).

4. Système semi-conducteur de puissance (2) selon l'une des revendications précédentes, le circuit d'attaque (6) comportant un seul contact (12a-c) pour des connexions (8a-c) similaires de différents interrupteurs semiconducteurs de puissance (4).

5. Système semi-conducteur de puissance (2) selon l'une des revendications précédentes, le circuit d'attaque (6) comprenant au moins un dispositif de mesure (20) détectant une tension (U_{KE}) entre deux des connexions (8a-c) de l'interrupteur semi-conducteur de puissance (4).

6. Système semi-conducteur de puissance (2) selon la revendication 5, comprenant un dispositif de mesure (20) propre à chaque interrupteur semi-conducteur de puissance (4).
